# EUROPEAN PATENT APPLICATION

(11) **EP 3 992 673 A1**
(43) Date of publication of application: **04.05.2022**
(21) Application number: 20832275.0
(22) Date of filing: 22.06.2020
(51) Int. Cl.: G02B 1/14, G09F 9/00, H05B 33/02, H01L 51/50

(54) **PHOTOCURABLE COMPOSITION, HARD COATING MATERIAL, CURED PRODUCT, CURED PRODUCT-ATTACHED SUBSTRATE, AND IMAGE DISPLAY DEVICE**

(30) Priority: 28.06.2019 JP 2019121268
(71) Applicant: Showa Denko Materials Co., Ltd., Tokyo 100-6606 (JP)
(72) Inventor: KURIMOTO Shigeru, Tokyo 100-6606 (JP); TACHIBANA Yuga, Tokyo 100-6606 (JP); KONDOU Hidekazu, Tokyo 100-6606 (JP); NAKADA Kazuaki, Tokyo 100-6606 (JP); TOKITA Yasutoshi, Tokyo 100-6606 (JP); IWAMOTO Kohsuke, Tokyo 100-6606 (JP); HISANO Kazuki, Tokyo 100-6606 (JP); WATABE Kaori, Tokyo 100-6606 (JP); OKADA Shiori, Tokyo 100-6606 (JP); KAMEI Junichi, Tokyo 100-6606 (JP)
(74) Representative: Berggren Oy
(86) International application number: PCT/JP2020/024426
(87) International publication number: WO 2020/262307

(57) **Abstract**

A photocurable composition for a hard coating material according to an aspect of the present invention contains (A) a polyfunctional polymerizable compound having three or more polymerizable double bonds, (B) an acrylic resin having a polymerizable double bond, (C) a polymerizable fluorine compound, and (D) a photopolymerization initiator.

## Description

### Technical Field

The present invention relates to a photocurable composition, a hard coating material, a cured product, a cured product-attached substrate, and an image display device.

### Background Art

In recent years, image display devices mounted with a touch panel typified by smartphones or tablet PCs have widely been used. A glass substrate has been generally used as a member of a touch sensor of these image display devices.

The image display devices are demanded to be thinner, lighter, and more flexible, and use of a transparent substrate has been studied in order to satisfy these demands. However, when a substrate having favorable optical properties is used alone, scratch resistance is not sufficient in many cases, and scratches generated on the substrate surface in the manufacturing process of a touch sensor or the like are likely to be problematic.

In this regard, it has been studied that scratch resistance is improved by providing a hard coating layer on a surface of a substrate (for example, Patent Literature 1).

### Citation List

### Patent Literature

Patent Literature 1: JP 2008-165041 A

### Summary of Invention

### Technical Problem

Although a certain degree of scratch resistance can also be provided by forming the hard coating layer, as the hard coating layer is abraded away over a long period of time, dirt or the like is likely to adhere to the hard coating layer. Thus, the scratch resistance of the hard coating layer is demanded to be further improved.

In this regard, a main object of the present invention is to provide a photocurable composition by which a coating layer excellent in scratch resistance and antifouling property can be formed when the photocurable composition is used for forming a coating layer covering a surface of a substrate.

### Solution to Problem

A photocurable composition according to an aspect of the present invention contains (A) a polyfunctional polymerizable compound having three or more polymerizable double bonds, (B) an acrylic resin having a polymerizable double bond, (C) a polymerizable fluorine compound, and (D) a photopolymerization initiator.

A double bond equivalent of the polyfunctional polymerizable compound may be 100 or more and 500 or less. A weight average molecular weight of the acrylic resin may be 4500 or more and 200000 or less. The fluorine compound may be a perfluoroalkyl ether compound.

A hard coating material according to an aspect of the present invention contains the aforementioned photocurable composition. A cured product according to an aspect of the present invention is a cured product of the aforementioned photocurable composition. A cured product-attached substrate according to an aspect of the present invention includes the aforementioned cured product and a substrate. An image display device according to an aspect of the present invention includes the aforementioned cured product.

### Advantageous Effects of Invention

According to the present invention, it is possible to provide a photocurable composition by which a coating layer excellent in scratch resistance and antifouling property can be formed when the photocurable composition is used for forming a coating layer covering a surface of a substrate.

### Description of Embodiments

Hereinafter, preferred embodiments of the present invention will be specifically described. However, the present invention is not limited to the following embodiments. In the present specification, the term "(meth)acryloyl" means methacryloyl or acryloyl. The term "(meth)acrylate" or the like is interpreted in the same manner.

### [Photocurable composition]

A photocurable composition for a hard coating material according to the present embodiment contains (A) a polyfunctional polymerizable compound having three or more polymerizable double bonds, (B) an acrylic resin having a polymerizable double bond, (C) a polymerizable fluorine compound, and (D) a photopolymerization initiator.

### (Component (A): polyfunctional polymerizable compound)

The polyfunctional polymerizable compound used as the component (A) has three or more polymerizable double bonds. Examples of a group containing a polymerizable double bond include a (meth)acryloyl group and a vinyl group. The number of polymerizable double bonds in the polyfunctional polymerizable compound may be 4 or more, 5 or more, or 6 or more, and may be 12 or less, 11 or less, or 10 or less. The term "polyfunctional" in the present specification means that three or more polymerizable double bonds are included.

The component (A) may have a monovalent group represented by Formula (1) or (2) below as the group containing a polymerizable double bond. As the result of the introduction of the group of Formula (1) or (2) as the group containing a polymerizable double bond into the component (A), while a coating layer to be formed from the photocurable composition maintains a high strength, the stress when the coating layer is deformed can be relaxed. Consequently, excellent flexibility of the coating layer is obtainable. Since the polyfunctional polymerizable compound has three or more polymerizable double bonds, the scratch resistance of the coating layer is improved. All the polymerizable double bonds in the polyfunctional polymerizable compound may be contained in the group of Formula (1) or (2), and the component (A) may have a group containing a polymerizable double bond other than the group of Formula (1) or (2).

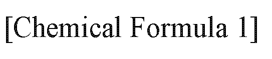

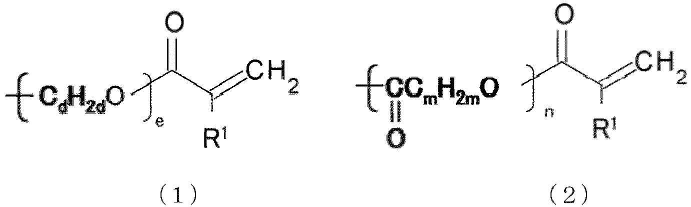

In Formula (1), R¹ represents a hydrogen atom or a methyl group, "d" represents an integer of 2 to 4, and "e" represents an integer of 1 to 6. In Formula (2), R¹ represents a hydrogen atom or a methyl group, "m" is 5, and "n" represents an integer of 1 to 4.

Examples of the component (A) include a urethane (meth)acrylate, a (meth)acrylic acid ester of alkylene oxide modified polyhydric alcohol, and a (meth)acrylic acid ester of caprolactone modified polyhydric alcohol. Use of a urethane (meth)acrylate or a (meth)acrylic acid ester of caprolactone modified polyhydric alcohol allows a protective film having excellent flexibility to be easily formed while maintaining high hardness. The polyfunctional polymerizable compound may be used singly or in combination of two or more kinds thereof.

In the present specification, "alkylene oxide modified" means a compound having an oxyethylene group or a polyoxyethylene group which is formed by adding an alkylene oxide such as ethylene oxide to the hydroxy group of an alcohol compound. Ethylene oxide modified may also be abbreviated as "EO modified", and propylene oxide modified may also be abbreviated as "PO modified", in some cases. A polyfunctional polymerizable compound derived from an alkylene oxide modified polyhydric alcohol has a monovalent group represented by Formula (1).

In the present specification, "caprolactone modified" means a compound having a divalent group which is formed by reacting the hydroxy group of an alcohol compound with caprolactone (such as ε-caprolactone). A poly functional polymerizable compound derived from a caprolactone modified polyhydric alcohol has a monovalent group represented by Formula (2-2).

The (meth)acrylic acid ester of alkylene oxide modified or caprolactone modified polyhydric alcohol is represented, for example, by Formula (20) below.

### (HO)_{y}-R¹⁰-(O-Z)ₓ (20)

In Formula (20), R¹⁰ represents a residue of a polyhydric alcohol having three or more hydroxy groups (a portion excluding the hydroxy groups), "Z" represents a monovalent group represented by Formula (1) or (2) or a monovalent group having a polymerizable double bond other than these groups described above, "x" represents an integer of 3 or more, "y" represents an integer of 0 or more, and "x + y" is equal to the valence of R¹⁰. A plurality of Z's in a molecule may be the same as or different from each other, and one or more of a plurality of Z's are monovalent group represented by Formula (2) or (2). "x + y" (the total number of hydroxy groups of polyhydric alcohol) may be 3 to 12, and "x" may be 3 to 9.

Examples of the polyhydric alcohol corresponding to R¹⁰ include at least one selected from the group consisting of polyglycerol, dipentaerythritol, pentaerythritol, and trimethylolpropane.

Examples of the polyfunctional polymerizable compound include alkylene oxide modified or caprolactone modified dipentaerythritol hexa(meth)acrylate, alkylene oxide modified or caprolactone modified dipentaerythritol penta(meth)acrylate, alkylene oxide modified or caprolactone modified dipentaerythritol tetra(meth)acrylate, alkylene oxide modified or caprolactone modified dipentaerythritol tri(meth)acrylate, alkylene oxide modified or caprolactone modified pentaerythritol tetra(meth)acrylate, alkylene oxide modified or caprolactone modified trimethylolpropane tri(meth)acrylate, and alkylene oxide modified or caprolactone modified polyglycerol polyacrylate.

The double bond equivalent of the component (A) may be 100 or more and 500 or less, 110 or more and 300 or less, or 115 or more and 250 or less. Thereby, from the viewpoint of the scratch resistance of a cured film, a more excellent effect can be obtained. The double bond equivalent of the component (A) is defined by dividing the molecular weight of the component (A) by the number of polymerizable double bonds in the same molecule.

The photocurable composition may contain 40 parts by mass or more and 95 parts by mass or less, 45 parts by mass or more and 93 parts by mass or less, or 50 parts by mass or more and 90 parts by mass or less of the component (A) with respect to 100 parts by mass of the total amount of the component (A) and the component (B). When the amount of the component (A) is in this range, further improved levels of both the scratch resistance and the antifouling property can be achieved. The component (A) may be used singly or in combination of two or more kinds thereof.

### (Component (B): acrylic resin having polymerizable double bond)

The acrylic resin having a polymerizable double bond that is the component (B) may have, for example, a main chain consisting of a copolymer containing a (meth)acrylic acid ester as a monomer unit and a side chain bonded to the main chain and containing a polymerizable double bond. The side chain containing a polymerizable double bond typically contains a (meth)acryloyl group, although not limited thereto. The component (B) is an acrylic resin having a structure different from those of the component (A) and the component (C).

The component (B) can be obtained, for example, by a method including: copolymerizing one or two or more types of (meth)acrylic acid esters (a1) and one or two or more types of polymerizable compounds (a2) having a reactive functional group so as to obtain an acrylic resin having a reactive functional group; and reacting one or two or more types of compounds (b) having a functional group reactive with the reactive functional group of the acrylic resin and a polymerizable double bond with the acrylic resin so as to introduce the polymerizable double bond into the side chain of the acrylic resin.

The (meth)acrylic acid ester (a1) may be, for example, at least one selected from the group consisting of a straight-chain or branched alkyl (meth)acrylate, an alicyclic (meth)acrylate, an aromatic (meth)acrylate, an alkoxyalkyl (meth)acrylate, an alkoxy(poly)alkylene glycol (meth)acrylate, an alkoxyalkoxyalkyl (meth)acrylate, an octafluoropentyl (meth)acrylate, and a dialkylaminoalkyl (meth)acrylate.

Examples of the straight-chain or branched alkyl (meth)acrylate include methyl (meth)acrylate, ethyl (meth)acrylate, n-propyl (meth)acrylate, n-butyl (meth)acrylate, isobutyl (meth)acrylate, t-butyl (meth)acrylate, ethylhexyl (meth)acrylate, stearyl (meth)acrylate, lauryl (meth)acrylate, and tridecyl (meth)acrylate.

Examples of the alicyclic (meth)acrylate include cyclohexyl (meth)acrylate, isobornyl (meth)acrylate, and dicyclopentanyl (meth)acrylate. Examples of the aromatic (meth)acrylate include phenoxyethyl (meth)acrylate.

Examples of the alkoxy(poly)alkylene glycol (meth)acrylate include methoxy diethylene glycol (meth)acrylate, ethoxy diethylene glycol (meth)acrylate, methoxy triethylene glycol (meth)acrylate, butoxy triethylene glycol (meth)acrylate, and methoxy dipropylene glycol (meth)acrylate.

Examples of the alkoxyalkyl (meth)acrylate include ethoxyethyl (meth)acrylate and butoxyethyl (meth)acrylate. Examples of the alkoxyalkoxyalkyl (meth)acrylate include 2-methoxyethoxyethyl (meth)acrylate and 2-ethoxyethoxyethyl (meth)acrylate.

Examples of the octafluoropentyl (meth)acrylate include 1H,1H,5H-octafluoropentyl (meth)acrylate.

Examples of the dialkylaminoalkyl (meth)acrylate include N,N-dimethylaminoethyl (meth)acrylate and N,N-diethylaminoethyl (meth)acrylate.

The polymerizable compound (a2) may have one or more reactive functional groups selected from the group consisting of an epoxy group and a hydroxy group. The epoxy group and the hydroxy group have favorable reactivity with the compound (b) having a carboxyl group, an isocyanate group, or the like, which is preferred.

Examples of the polymerizable compound (a2) having an epoxy group as the reactive functional group include a (meth)acrylate having an epoxy group such as glycidyl (meth)acrylate and 3,4-epoxycyclohexyl (meth)acrylate.

Examples of the polymerizable compound (a2) having a hydroxy group as the reactive functional group include a hydroxyalkyl (meth)acrylate such as 2-hydroxyethyl (meth)acrylate, 2-hydroxybutyl (meth)acrylate, and 2-hydroxypropyl (meth)acrylate.

The acrylic resin may contain other polymerizable compounds as monomer units in addition to the (meth)acrylic acid ester (a1) and the polymerizable compound (a2). Examples of the other polymerizable compounds include an aromatic vinyl compound such as styrene and vinyltoluene.

The compound (b) having a polymerizable double bond has at least one functional group reactive with the reactive functional group (epoxy group, hydroxy group, or the like) of the polymerizable compound (a2) and selected from the group consisting of a carboxyl group, an isocyanate group, and the like.

Specific examples of the compound (b) having a carboxyl group include (meth)acrylic acid, a dimer of (meth)acrylic acid (for example, trade name "ARONIX M5600" manufactured by TOAGOSEI CO., LTD.), caprolactone modified (meth)acrylic acid (for example, ω-carboxy-polycaprolactone monoacrylate, trade name "ARONIX M5300" manufactured by TOAGOSEI CO., LTD.), a compound obtained by the ring-opening reaction of a (meth)acrylate having a hydroxy group and carboxylic anhydride (for example, phthalic acid monohydroxy ethyl acrylate, trade name "ARONIX M5400" manufactured by TOAGOSEI CO., LTD.), and β-acryloyl oxyethyl hydrogen succinate (for example, trade name "NK ESTER A-SA" manufactured by SHIN-NAKAMURA CHEMICAL Co., Ltd.).

Specific examples of the compound (b) having an isocyanate group include methacryloyloxyethyl isocyanate (for example, trade name "KARENZ MOI" manufactured by Showa Denko K.K.).

The double bond equivalent of the component (B) may be 220 or more and 2500 or less, 230 or more and 1000 or less, or 240 or more and 500 or less, from the viewpoint of further improving scratch resistance. In the present specification, the double bond equivalent of the acrylic resin can be calculated by the formula: Double bond equivalent = (total mass parts of monomers used in synthesis)/(number of moles of acrylic acid used in synthesis) while the number of moles of acrylic acid used in synthesis is regarded as the number of polymerizable double bonds in the acrylic resin. The double bond equivalent calculated from this formula can be regarded to correspond to an average value of the double bond equivalent of the synthesized acrylic resin.

The weight average molecular weight (Mw) of the component (B) may be 4500 or more and 200000 or less, 4800 or more and 100000 or less, or 5000 or more and 50000 or less. When the Mw of the component (B) is 45000 or more, scratch resistance is more likely to be improved, and when the Mw of the component (B) is 200000 or less, flexibility is more likely to be improved. Herein, the Mw means a standard polystyrene-equivalent value measured by gel permeation chromatography.

The photocurable composition may contain the component (B) in a ratio of 5 parts by mass or more and 60 parts by mass or less, 7 parts by mass or more and 55 parts by mass or less, or 10 parts by mass or more and 50 parts by mass or less with respect to 100 parts by mass of the total amount of the component (A) and the component (B). When the amount of the component (B) is in this range, further improved levels of both the scratch resistance and the antifouling property can be achieved. The component (B) may be used singly or in combination of two or more kinds thereof.

### (Component (C): polymerizable fluorine compound)

The polymerizable fluorine compound that is the component (C) may have a group having a polymerizable double bond and a perfluoroether group.

Examples of the group having a polymerizable double bond include a (meth)acryloyl group and a vinyl group. The perfluoroether group may be, for example, -(OC₄F₈)a-(OC₃F₆)b-(OC₂F₄)c-(OCF₂)_{d}-, and "a", "b", "c", and "d" each independently are 0 to 200, and the sum of "a", "b", "c", and "d" is 1 or more. The sum of "a", "b", "c", and "d" may be 5 to 300, 10 to 200, or 10 to 100. Examples of the component (C) include a perfluoropolyether compound having a (meth)acryloyl group.

When the polymerizable fluorine compound according to the present embodiment has a polymerizable double bond, the component (A) and the component (B) are likely to be compatible with each other, and adhesion of a cured film with respect to a non-fluorinated substrate can be improved. Furthermore, when a perfluoro group is likely to be distributed in the vicinity of the surface of the cured film that is a side not in contact with the substrate, the scratch resistance and the antifouling property of the cured film can be enhanced.

From the viewpoint of further improving the scratch resistance and the antifouling property of the cured film, the polymerizable fluorine compound may further have a group having an active hydrogen such as a hydroxy group.

The photocurable composition may contain the component (C) in a ratio of 0.1 parts by mass or more and 10 parts by mass or less, 0.2 parts by mass or more and 8 parts by mass or less, or 0.5 parts by mass or more and 5 parts by mass or less with respect to 100 parts by mass of the total amount of the component (A) and the component (B). When the amount of the component (C) is in this range, further improved levels of both the scratch resistance and the antifouling property can be achieved. The component (C) may be used singly or in combination of two or more kinds thereof.

### (Component (D): photopolymerization initiator)

The photopolymerization initiator that is the component (D) is a compound that initiates photopolymerization by generating a radical under irradiation of active rays such as ultraviolet rays. Examples of the photopolymerization initiator include alkylphenone-based photopolymerization initiators such as 4-phenoxydichloroacetophenone, 4-t-butyl-dichloroacetophenone, 4-t-butyl-trichloroacetophenone, diethoxyacetophenone, 2-hydroxy-2-methyl-2-phenylpropane-2-one, 2-(4-isopropylphenyl-2-hydroxy-2-methylpropan-2-one, 2-(4-dodecylphenyl)-2-hydroxy-2-methylpropan-2-one, 4-(2-hydroxyethoxy)-phenyl-(2-hydroxy-2-propyl)ketone, 1-hydroxycyclohexyl phenyl ketone, and 2-methyl-2-[4-(methylthio)phenyl]-2-morpholinopropan-2; benzoin-based photopolymerization initiators such as benzoin, benzoin methyl ether, benzoin ethyl ether, benzoin isopropyl ether, benzoin isobutyl ether, and benzyl dimethyl ketal; benzophenone-based photopolymerization initiators such as benzophenone, 4-methylbenzophenone, 2-methylbenzophenone, benzoylbenzoic acid, methyl benzoylbenzoate, 4-phenylbenzophenone, hydroxybenzophenone, 4-benzoyl-4'-methyl diphenyl sulfide, and 3,3'-dimethyl-4-methoxybenzophenone; and thioxanthone-based photopolymerization initiators such as thioxanthone, 2-chlorthioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone.

The photocurable composition may contain the component (D) in a ratio of 0.01 parts by mass or more and 10 parts by mass or less, 0.1 parts by mass or more and 6 parts by mass or less, or 1 part by mass or more and 5 parts by mass or less with respect to 100 parts by mass of the total amount of the component (A) and the component (B). When the amount of the photopolymerizable compound is in this range, particularly favorable photopolymerizability is obtainable. The component (D) may be used singly or in combination of two or more kinds thereof.

The photocurable composition may further contain a solvent which dissolves or disperses the components (A) to (D) for the purposes of adjusting the viscosity, the coatability, the thickness of the coating film, and the like.

Examples of the solvent include ketones such as acetone, methyl ethyl ketone, methyl isobutyl ketone, cyclopentanone, and cyclohexanone; esters such as ethyl acetate and butyl acetate; alcohols such as isopropyl alcohol and ethyl alcohol; polyhydric alcohol alkyl ethers such as ethylene glycol monoethyl ether, ethylene glycol monobutyl ether, ethylene glycol dimethyl ether, ethylene glycol diethyl ether, propylene glycol monomethyl ether, propylene glycol dimethyl ether, diethylene glycol monomethyl ether, diethylene glycol monobutyl ether, and diethylene glycol dimethyl ether; aromatic hydrocarbons such as benzene, toluene, xylene, methoxybenzene, and 1,2-dimethoxybenzene; and halogenated hydrocarbons such as chloroform, dichloromethane, dichloroethane, tetrachloroethane, trichloroethylene, tetrachloroethylene, and chlorobenzene. The solvent may be used singly or in combination of two or more kinds thereof.

The photocurable composition may further contain components other than the components (A) to (D) without departing from the scope of the present invention.

The photocurable composition may contain inorganic fine particles for the purpose of controlling the optical properties such as a refractive index or enhancing the anti-blocking properties. The average particle size of the inorganic fine particles may be 1 to 1000 nm, or 5 to 200 nm. Examples of the inorganic fine particles include silicon dioxide particles, tin oxide particles, calcium carbonate particles, zirconium oxide particles, talc, kaolin, barium sulfate particles, titanium dioxide particles, aluminum oxide particles, and calcium sulfate particles. The inorganic fine particles may be surface-treated.

The photocurable composition may further contain additives such as an antifouling agent, a flame retardant, an antioxidant, a dispersant, a UV absorber, a pigment, a plasticizer, a surfactant, and a thixotropic agent.

### [Hard coating material]

The photocurable composition according to the present embodiment can be used as a hard coating material for forming a hard coating layer covering the surface of the substrate to obtain a hard coating film. The hard coating material of the present embodiment contains the aforementioned photocurable composition, and the hard coating film is composed of a substrate and a coating layer.

As the substrate, arbitrary substrates such as metal, glass, and plastic substrates can be used. The substrate is preferably a plastic film substrate from the viewpoint of adhesion.

Examples of the plastic film substrate include films of polyethylene terephthalate (PET), triacetylcellulose (TAC), polyethylene naphthalate (PEN), polymethyl methacrylate (PMMA), polycarbonate (PC), polyimide (PI), polyethylene (PE), polypropylene (PP), polyvinyl alcohol (PVA), polyvinyl chloride (PVC), a cycloolefin copolymer (COC), a cycloolefin polymer (COP), a norbornene-containing resin, polyether sulfone, cellophane, aromatic polyamide, and combinations thereof.

From the reasons such as adhesion improvement, the plastic film substrate may be subjected to a surface treatment such as a corona treatment or a plasma treatment, and an undercoating agent (primer) may be applied to the plastic film substrate.

The thickness of the plastic film substrate is not particularly limited, and may be, for example, 10 to 300 µm, 40 to 200 µm, or 60 to 150 µm. The thickness of the coating layer may be, for example, 0.5 to 50 µm, 1 to 30 µm, or 5 to 20 µm.

The coating layer may be provided on one surface of the plastic film substrate, and may be provided on both surfaces of the plastic film substrate. The coating layer may cover the entire surface of the plastic film substrate, and may be a part of the surface of the plastic film substrate. Any layer (such as primer layer) may be provided between the coating layer and the plastic substrate.

The hard coating film can be produced, for example, by a method including a step of forming a film of a photocurable composition on a plastic film and a step of removing a solvent as necessary from the film of the photocurable composition and curing the photocurable composition with active energy rays or the like so as to form a cured film of the photocurable composition as a coating layer.

As the method of forming a film of a photocurable composition or the method of applying a photocurable composition to a plastic film substrate, a general coating method or printing method can be employed. As the coating method or printing method, for example, coating such as reverse coating, transfer roll coating, gravure roll coating, kiss coating, cast coating, spray coating, spin coating, dip coating, slot orifice coating, air doctor coating, bar coating, blade coating, dam coating, and die coating, and printing including intaglio printing such as gravure printing, and stencil printings such as screen printing can be used.

As the active energy rays for curing the photocurable composition, ultraviolet rays, electron beams, and the like can be used. The curable composition may be cured by heating. In this case, the photocurable composition may contain a thermal-radical polymerization initiator.

A cured film (coating layer) formed from the photocurable composition according to the present embodiment has excellent scratch resistance. The scratch resistance can be evaluated, for example, by a method of visually checking scratches on the surface of a coating layer when a #0000 steel wool is pressed onto the surface of the coating layer with a predetermined load and reciprocated at the same time. The scratch resistance can be quantitatively determined based on the maximum load value causing no scratch confirmed on the surface when the load is increased stepwise. This maximum value may be 1000 gf or more, 1500 gf or more, or 2000 gf or more, in order to prevent scratches on the surface of the film in the manufacturing process of an image display device such as a touch panel. When this value is equal to or more than these lower limit values, scratches caused by friction between the coating layer and a metal shaft or the like during transportation of the film can be particularly effectively prevented. According to the curable composition according to the present embodiment, a coating layer having such excellent scratch resistance can be formed. The upper limit value of the scratch resistance is not particularly limited, and is typically 2500 gf or less.

The surface of the cured film according to the present embodiment has excellent scratch resistance, and thus has high water repellency and oil repellency and is difficult to get dirty. The contact angle between the cured film and water as measured in the scratch resistance is preferably 100° or more and more preferably 105° or more at 23°C.

The cured film according to the present embodiment preferably contains fluorine in the outermost surface and the inside of the cured film. The atomic ratio of fluorine in the outermost surface of the cured film may be 3 atomic% or more, 5 atomic% or more, 10 atomic% or more, or 12 atomic% or more, from the viewpoint of enhancing water repellency. The upper limit value of the atomic ratio of fluorine in the outermost surface of the cured film may be 50 atomic% or less. The atomic ratio of fluorine in the intermediate portion of the cured film may be 1 atomic% or less, 0.5 atomic% or less, 0.3 atomic% or less, 0.2 atomic% or less, or 0.1 atomic% or less, from the viewpoint of scratch resistance and the appearance of the cured film. The lower limit value of the atomic ratio of fluorine in the intermediate portion of the cured film may be 0.001 atomic% or more. The atomic ratio of fluorine can be measured using an X-ray photoelectron spectrometer. When the content of fluorine in the outermost surface of the cured film is 3 atomic% or more and the content of fluorine in the intermediate portion of the cured film is 1 atomic% or less, improved levels of all of the water repellency, the abrasion resistance, and the appearance of the cured film can be achieved.

### [Cured product-attached substrate and image display device]

The cured product according to the present embodiment can be formed by curing the photocurable composition by using active energy rays such as ultraviolet rays or electron beams, and further, may be cured by heating. The cured product according to the present embodiment may be, for example, a cured film.

A cured product-attached substrate according to the present embodiment includes the aforementioned cured product and a substrate. In the present embodiment, the same aspect which has been described above can be applied to the substrate, and the substrate is preferably a plastic film substrate from the viewpoint of adhesion. The cured product-attached substrate according to the present embodiment can be suitably used, for example, as a hard coating film.

An image display device according to the present embodiment includes the aforementioned cured product. Examples of the image display device include a plasma display panel (PDP), a liquid-crystal display (LCD), a cathode-ray tube (CRT), a field emission display (FED), an organic EL display (OELD), a 3D display, and an electronic paper (EP).

### Examples

Hereinafter, the present invention will be more specifically described by means of Examples. However, the present invention is not limited to these Examples.

As the component (A), the following polyfunctional polymerizable compounds were prepared.
A1: Decafunctional urethane acrylate (double bond equivalent: 116, trade name "HITALOID 7909-1" manufactured by Hitachi Chemical Co., Ltd.)
A2: Hexafunctional urethane acrylate (double bond equivalent: 123, trade name "HITALOID 7902-1" manufactured by Hitachi Chemical Co., Ltd.)
A3: Caprolactone modified dipentaerythritol hexaacrylate (double bond equivalent: 135, 2 moles of caprolactone added, hexafunctional, trade name "KAYARAD DPCA-20" manufactured by Nippon Kayaku Co., Ltd.)

As the component (B), the following acrylic resins having a polymerizable double bond were synthesized.

### (Synthesis Example B1)

In propylene glycol monomethyl ether (MIBK), 80 parts by mass of glycidyl methacrylate (GMA), 18 parts by mass of methyl methacrylate (MMA), and 2 parts by mass of ethyl acrylate (EA) were solution-polymerized according to a conventional method to synthesize an acrylic resin having an epoxy group derived from glycidyl methacrylate. Through the reaction of the epoxy group of the acrylic resin thus obtained with an acrylic acid, an acrylic resin having an acryloyl group was obtained. To one equivalent of GMA for use in the polymerization reaction, one equivalent of acrylic acid was used for the reaction. The Mw of the acrylic resin (B1) thus obtained was 15000, and the double bond equivalent thereof was 256.

### (Synthesis Example B2)

An acrylic resin (B2) having an Mw of 5000 was obtained in the same manner as in Synthesis Example B1, except that the time of the solution polymerization was changed.

### (Synthesis Example B3)

An acrylic resin (B3) having an Mw of 50000 was obtained in the same manner as in Synthesis Example B1, except that the time of the solution polymerization was changed.

The Mw is a value that is measured by a gel permeation chromatography (GPC) method and obtained by conversion with a standard polystyrene calibration curve. The measurement conditions for the GPC method are as follows.
Apparatus: HLC-8320GPC (with built-in RI detector) manufactured by Tosoh Corporation
Detector: RI (differential refractometer)
Solvent: Tetrahydrofuran
Guard column: TSK-guard column SuperMP(HZ)-H (one piece) Guard column size: 4.6 mm (ID) × 20 mm
Column: TSK-GEL SuperMulitipore HZ-H manufactured by Tosoh Corporation (three columns connected)
Column size: 4.6 mm (ID) × 150 mm
Temperature: 40°C
Sample concentration: 0.01 g/5 mL
Injection amount: 10 µL
Flow rate: 0.35 mL/min

As the (component (C), the following polymerizable fluorine compounds were prepared.
C1: Perfluoropolyether compound having a (meth)acryloyl group (trade name "OPTOOL DAC-HP" manufactured by Daikin Industries, Ltd.)
C2): Perfluoropolyether compound having a (meth)acryloyl group (trade name "MEGAFACE RS-75" manufactured by DIC Corporation)
C3: Perfluoropolyether compound having a (meth)acryloyl group (trade name "Fluorolink AD-1700" manufactured by Solvay Specialty Polymers Japan K.K.)
C4: Perfluoropolyether compound having a (meth)acryloyl group (trade name "Fluorolink MD-700" manufactured by Solvay Specialty Polymers Japan K.K.)

As the component (D), the following photopolymerization initiator was prepared.
D1: 1-Hydroxycyclohexyl phenyl ketone (Omnirad 184 manufactured by IGM Resins B.V.)

### [Preparation of photocurable composition]

The components (A) to (D) were mixed with 150 parts by mass of propylene glycol monomethyl ether at a blending amount (parts by mass) shown in Table 1 or Table 2 and stirred at 40°C for 1 hour to prepare each of photocurable compositions of Examples and Comparative Examples.

### [Evaluation]

As the substrate, a PET film having a thickness of 100 µm (trade name "COSMOSHINE A4300 manufactured by TOYOBO CO., LTD.) and a PC film having a thickness of 100 µm (trade name "Iupilon FE2000" manufactured by MITSUBISHI GAS CHEMICAL COMPANY, INC.) were prepared. The photocurable composition was applied on one surface of the substrate using a bar coater and dried in a hot-air dryer set at 80°C for 1 minute to form a coating film having a thickness of 10 µm. The coating film was irradiated with ultraviolet rays at a light intensity of 400 mJ/cm² using a conveyor-type high pressure mercury lamp so as to cure the photocurable composition, thereby forming a cured film as the coating layer covering one surface of the substrate. During the ultraviolet irradiation, nitrogen was introduced, so that the oxygen concentration was maintained at 10 ppm or less.

### (Scratch resistance test)

A #0000 steel wool was pressed onto the surface of the coating layer with a predetermined load and reciprocated 1000 times at a speed of 2000 mm/min in the distance of 20 mm at the same time by using a surface property measuring device (HEIDON TYPE: 14FW manufactured by Shinto Scientific Co., Ltd.). Thereafter, the scratch state of the surface of the coating layer was visually checked. A case where the maximum load value causing no scratch confirmed is 2000 gf or more was determined as "A", a case where the maximum load value causing no scratch confirmed is 1000 gf or more and less than 2000 gf was determined as "B", and a case where the maximum load value causing no scratch confirmed is less than 1000 gf was determined as "C".

### (Contact angle)

Water was dropped with respect to the surface of the coating layer and the contact angle of water was measured. In the measurement, a contact angle meter (trade name: Drop Master 300 manufactured by Kyowa Interface Science Co., Ltd.) was used. As for measurement conditions, a temperature was set to 23°C, the drop amount of the probe liquid was set to 2 µL, and the measurement timing was set to 5 seconds after the drop of probe liquid. The contact angle was measured before and after the scratch resistance test. A case where the contact angle is 105° or more was determined as "A", a case where the contact angle is 100° or more and less than 105° was determined as "B", and a case where the contact angle is less than 100° was determined as "C".

### (Atomic ratio of fluorine)

The atomic ratio of fluorine atom in the thickness direction with respect to the whole atoms constituting the cured film was measured using a fully automated X-ray photoelectron spectrometer (trade name: Thermo Scientific K-Alpha manufactured by Thermo Fisher Scientific Inc.) by argon gas cluster ion beam (Ar-GCIB) etching/X-ray photoelectron spectroscopy (XPS). The measurement conditions are as follows.
X ray: Al-Kα ray (100 µm, 14 W, 12 kV)
Measurement area: Diameter of 150 µm
Pass Energy: 50 eV, Step Energy: 0.1 eV
Argon gas cluster ion beam etching conditions: Ion energy 4000 eV, Cluster size: Large, Irradiation range: Diameter of 1.64 mm

**[Table 1]**

| Example | | 1 | 2 | 3 | 4 | 5 | 6 | 7 | 8 | 9 | 10 | 11 |
|---|---|---|---|---|---|---|---|---|---|---|---|---|
| Component (A) | A1 | 90 | 90 | 90 | 70 | 50 | - | - | 90 | 90 | 90 | 90 |
| | A2 | - | - | - | - | - | 90 | - | - | - | - | - |
| | A3 | - | - | - | - | - | - | 90 | - | - | - | - |
| Component (B) | B1 | 10 | - | - | 30 | 50 | 10 | 10 | 10 | 10 | 10 | 10 |
| | B2 | - | 10 | - | - | - | - | - | - | - | - | - |
| | B3 | - | - | 10 | - | - | - | - | - | - | - | - |
| Component (C) | C1 | 1 | 1 | 1 | 1 | 1 | 1 | 1 | 0.2 | 2 | 1 | - |
| | C2 | - | - | - | - | - | - | - | - | - | - | 1 |
| | C3 | - | - | - | - | - | - | - | - | - | - | 0.9 |
| | C4 | - | - | - | - | - | - | - | - | - | - | 0.1 |
| Component (D) | D1 | 3 | 3 | 3 | 3 | 3 | 3 | 3 | 3 | 3 | 3 | 3 |
| Substrate | | PET | PET | PET | PET | PET | PET | PET | PET | PET | PC | PET |
| Contact angle | Initial stage | A | A | A | A | A | A | A | B | A | A | A |
| | After abrasion | A | A | A | B | B | A | B | B | A | A | B |
| Scratch resistance | | A | A | A | B | B | A | B | A | A | A | A |
| Fluorine (atomic%) | Outermost surface | 14 | 14 | 14 | 14 | 14 | 14 | 14 | 5 | 18 | 14 | 6 |
| | In term ediate portion | 0.2 | 0.2 | 0.2 | 0.2 | 0.2 | 0.2 | 0.2 | 0.05 | 0.3 | 0.2 | 0.1 |

**[Table 2]**

| Comparative Example | | 1 | 2 | 3 |
|---|---|---|---|---|
| Component (A) | A1 | 100 | 100 | - |
| | A2 | - | - | - |
| | A3 | - | - | - |
| Component (B) | B1 | - | - | 100 |
| | B2 | - | - | - |
| | B3 | - | - | - |
| Component (C) | C1 | 1 | - | 1 |
| | C2 | - | 1 | - |
| | C3 | - | - | - |
| | C4 | - | - | - |
| Component (D) | D1 | 3 | 3 | 3 |
| Substrate | | PET | PET | PET |
| Contact angle | Initial stage | A | A | A |
| | After abrasion | C | C | C |
| Scratch resistance | | C | C | C |
| Fluorine (atomic%) | Outermost surface | 5 | 2.5 | 10 |
| | Intermediate portion | 0.2 | 0.2 | 0.2 |

## Claims

1. A photocurable composition for a hard coating material, comprising: (A) a polyfunctional polymerizable compound having three or more polymerizable double bonds; (B) an acrylic resin having a polymerizable double bond; (C) a polymerizable fluorine compound; and (D) a photopolymerization initiator.

2. The photocurable composition according to claim 1, wherein a double bond equivalent of the polyfunctional polymerizable compound is 100 or more and 500 or less.

3. The photocurable composition according to claim 1 or 2, wherein a weight average molecular weight of the acrylic resin is 4500 or more and 200000 or less.

4. The photocurable composition according to any one of claims 1 to 3, wherein the polymerizable fluorine compound is a perfluoropolyether compound having a (meth)acryloyl group.

5. A hard coating material comprising the photocurable composition according to any one of claims 1 to 4.

6. A cured product of the photocurable composition according to any one of claims 1 to 4.

7. The cured product according to claim 6, wherein an atomic ratio of fluorine in the outermost surface of the cured product is 3 atomic% or more, and an atomic ratio of fluorine in an intermediate portion of the cured product is 1 atomic% or less.

8. A cured product-attached substrate comprising: the cured product according to claim 6 or 7; and a substrate.

9. An image display device comprising the cured product according to any one of claims 6 and 7.
